# EUROPÄISCHE PATENTSCHRIFT

(11) **EP 3 707 790 B1**
(45) Veröffentlichungstag und Bekanntmachung des Hinweises auf die Patenterteilung: **28.10.2026**
(21) Anmeldenummer: 18800140.8
(22) Anmeldetag: 08.11.2018
(51) Int. Cl.: H01T 2/02, H01T 1/22, H01T 1/24, H01T 15/00, H01T 21/00, H01T 4/12

(54) **TRIGGERBARE FUNKENSTRECKE, SCHALTKREIS MIT TRIGGERBARER FUNKENSTRECKE UND VERFAHREN ZUR HERSTELLUNG EINER TRIGGERBAREN FUNKENSTRECKE**
TRIGGERABLE SPARK GAP, SWITCHING CIRCUIT HAVING A TRIGGERABLE SPARK GAP, AND PROCESS FOR MANUFACTURING A TRIGGERABLE SPARK GAP
ÉCLATEUR À DÉCLENCHEMENT, CIRCUIT AVEC ÉCLATEUR À DÉCLENCHEMENT ET PROCÉDÉ DE FABRICATION D'UN ÉCLATEUR À DÉCLENCHEMENT

(30) Priorität: 10.11.2017 DE 102017126371
(43) Veröffentlichungstag der Anmeldung: 16.09.2020
(73) Patentinhaber: TDK Electronics AG, 81671 München (DE)
(72) Erfinder: DAEUMER, Wolfgang, 15738 Zeuthen (DE); MEWES, Michael, 12167 Berlin (DE); FANG, Zhipeng, Xiaogan Hubei 432104 (CN)
(74) Vertreter: Epping - Hermann - Fischer
(86) Internationale Anmeldenummer: PCT/EP2018/080621
(87) Internationale Veröffentlichungsnummer: WO 2019/092108

(56) Entgegenhaltungen:
- DD-A3- 273 566
- DE-A1- 1 763 559
- DE-A1- 102004 006 988
- DE-A1- 2 742 502
- DE-A1- 3 100 924
- DE-A1- 3 723 571
- SU-A2- 1 081 718
- US-A1- 2006 209 485

## Beschreibung

Die Erfindung betrifft triggerbare Funkenstrecken mit erhöhter Lebensdauer, Schaltkreise mit solchen Funkenstrecken und Verfahren zur Herstellung solcher Funkenstrecken.

Triggerbare Funkenstrecken eignen sich als Schalter zum Schalten von Hochspannungs- und Hochstrompulsen. Dazu hat eine Funkenstrecke eine Triggerelektrode, eine in deren Nähe angeordnete beiliegende Elektrode und eine Gegenelektrode. Zwischen der beiliegenden Elektrode und der Gegenelektrode kann eine Spannung angelegt werden. Über ein Signal an die Triggerelektrode, z.B. ein bestimmtes elektrisches Potential, kann ein Hochspannungsüberschlag zwischen der beiliegenden Elektrode und der Gegenelektrode ausgelöst (getriggert) werden.

Funkenstrecken sind z.B. aus der DE 102015114846 A1 bekannt. Aus der US 2006/209485 A1 sind Entladungsröhren ("discharge tube") bekannt. Aus der DE 3100924 A1 und aus der DE 2742502 A1 sind Gasentladungs-Überspannungsableiter mit einer ähnlichen Geometrie bekannt. Aus der DE 102004006988 A1 sind Überspannungsschutzeinrichtungen auf Funkenstreckenbasis bekannt. Aus der DE 1763559 A1 sind triggerbare Funkenstrecken mit koaxialem Aufbau und radialem Stromfluss bekannt. Die DE 3723571 A1 betrifft ebenfalls Überspannungs-Schutzelemente. Aus der DD 273 566 A3 und der SU 1 081 718 A2 sind triggerbare Funkenstrecken bekannt. Die DD 273 566 A3 offenbart die Merkmale des Oberbegriffs des Anspruchs 1.

Ein Maß für die Lebensdauer einer Funkenstrecke ist **z.B.** die Zahl der Schaltvorgänge, die zuverlässig ausgelöst werden können, bevor Fehler beim Schalten auftreten. Materialtransport von den Elektroden hin zu Wandbereichen, die die Elektroden galvanisch trennen sollen, führt zu einer allmählichen Verringerung der Isolation zwischen den Elektroden, sodass die Funkenstrecke ab einem kritischen Isolationswiderstand nicht mehr zuverlässig betrieben werden kann.

Bekannt Maßnahmen zur Verlängerung der Lebensdauer umfassen **z.B.** das größere Dimensionieren der Funkenstrecke. Dadurch wird das von den Elektroden abgetragene Material auf einer größeren Fläche verteilt, wodurch eine kritische Isolation länger aufrechterhalten werden kann. Eine weitere Maßnahme besteht **z.B.** darin, den Hauptentladungsspalt zu reduzieren oder die Länge der Schaltfunkenstrecke zu erhöhen. Weiterhin ist es möglich, die Wandbereiche durch einen größeren Elektrodendurchmesser besser abzuschirmen oder Hinterschneidungen in die Topologie einzufügen.

Problematisch bei bekannten Maßnahmen zur Verlängerung der Lebensdauer ist allerdings da Tatsache, dass der Platzbedarf der Funkenstrecke erhöht wird und/oder mehr Material für die Herstellung der Funkenstrecke benötigt wird. Ersteres ist ungünstig, da stets geringe Außendimensionen von Herstellern von elektrischen Bauelementen mit Funkenstrecken bevorzugt werden. Letzteres ist ungünstig, da dadurch Materialkosten und Herstellungskosten steigen.

Es besteht deshalb der Wunsch nach triggerbaren Funkenstrecken mit verlängerter Lebensdauer, die mit kleinen Abmessungen realisierbar sind und deren Herstellungsaufwand und Herstellungskosten bezogen auf eine Erweiterung der Lebensdauer auf ein Minimum reduziert sind.

Dazu wird ein triggerbare Funkenstrecke, ein Schaltkreis mit triggerbarer Funkenstrecke und ein Verfahren zur Herstellung einer triggerbaren Funkenstrecke gemäß den unabhängigen Ansprüchen angegeben. Abhängige Ansprüche geben vorteilhafte Ausgestaltungen **an.**

Die triggerbare Funkenstrecke umfasst eine Triggerelektrode, eine beiliegende Elektrode und eine Gegenelektrode. Die beiliegende Elektrode ist bei der Triggerelektrode, also in der Nähe der Triggerelektrode relativ zum Abstand zwischen Triggerelektrode und Gegenelektrode, angeordnet. Die triggerbare Funkenstrecke umfasst ferner einen Spalt zwischen der Gegenelektrode und der beiliegenden Elektrode. Der Abstand zwischen Triggerelektrode und beiliegender Elektrode ist kleiner als der Abstand zwischen der Triggerelektrode und der Gegenelektrode. Der Abstand zwischen Triggerelektrode und Gegenelektrode ist kleiner als der Abstand zwischen der beiliegenden Elektrode und der Gegenelektrode. Die Gegenelektrode und/oder die beiliegende Elektrode umfassen eine erste Phase aus einem ersten Material und eine zweite Phase aus einem zweiten Material. Das zweite Material hat eine niedrigere Elektronen-Austrittsenergie als das erste Material.

Die Triggerelektrode ist vorzugsweise diejenige Elektrode, über die ein Schaltvorgang der triggerbaren Funkenstrecke ausgelöst werden kann. Durch das Auslösen (Triggern) eines Schaltvorgangs wird ein elektrischer Überschlag über den Spalt zwischen der Gegenelektrode und der beiliegenden Elektrode induziert.

Nachfolgend wird die Wirkung des zweiten Materials am Beispiel der Gegenelektrode erläutert. Analoges gilt für den entsprechenden zweiphasigen Aufbau der beiliegenden Elektrode.

Das Vorsehen einer Phasengrenze innerhalb der Gegenelektrode, **d.h.** einer Phasenelektrode zwischen dem ersten Material der Gegenelektrode und dem zweiten Material der Gegenelektrode verändert die elektrochemischen und elektrophysikalischen Eigenschaften im Innern der Funkenstrecke so, dass eine deutliche Erhöhung der Lebensdauer der Funkenstrecke erhalten werden kann. Bei geeigneter Materialwahl ist es möglich, die Lebensdauer der triggerbaren Funkenstrecke mindestens zu verdoppeln.

Es ist möglich, dass das erste Material ein für die Verwendung als Gegenelektrode bekanntes Material ist. Als erstes Material kommen Materialien mit hohen Schmelzpunkten infrage, die elektrisch leitend sind. Materialien, die einen hohen Schmelzpunkt, eine elektrische Mindestleitfähigkeit und darüber hinaus noch eine gute thermische Leitfähigkeit aufweisen, sind besonders bevorzugt.

Molybdän, Wolfram und intermetallische Verbindungen mit Lanthan kommen somit als erstes Material der Gegenelektrode und/oder der beiliegenden Elektrode infrage. Darüber hinaus sind auch Kupfer und Chrom als Komponenten für das erste Material und das zweite Material geeignet.

Als zweites Material der zweiten Phase der Gegenelektrode kommen insbesondere Materialien infrage, die den Übergangswiderstand der Elektrode und/oder die Bogenbrennspannung reduzieren. Hierfür erweisen sich glasartige Alkali- und Erdalkali-Verbindungen als günstige Wahl zur Elektronenemission.

Es wurde erkannt, dass eine Reduktion der Bogenbrennspannung die Verlustleistung im Innern der Funkenstrecke reduziert. Die Verlustleistung wiederum wirkt sich auf den Umfang des Materialtransports von den Elektroden an die Wände aus. Eine reduzierte Bogenbrennspannung führt damit indirekt zu einem verringerten Materialtransport und damit zu einer Verbesserung der Isolation zwischen den Elektroden.

Ferner ist es bevorzugt, dass das zweite Material eine geringe Abdampfrate aufweist.

Allerdings hat sich gezeigt, dass Materialien mit einer Abdampfrate die höher ist als die Abdampfrate konventioneller Gegenelektrodenmaterialien überraschenderweise trotzdem den Bau von Funkenstrecken mit verlängerter Lebensdauer ermöglicht.

Als geeignetes Material für das zweite Material der Gegenelektrode hat sich ein Material herausgestellt, das durch Erhitzen aus einer Glaspaste hervorgegangen ist.

Anspruch 1 definiert, dass das erste Material Molybdän, Wolfram, Chrom, Kupfer oder Lanthan umfasst oder aus Molybdän, Wolfram, Chrom, Kupfer oder Lanthan besteht und das zweite Material eine erhitzte Glaspaste oder glasartige Alkali- oder Erdalkali-Verbindungen umfasst.

Dieses Material kann als Beschichtung auf dem ersten Material aufgebracht werden. Es wird damit eine Beschichtung angegeben, die einen hohen Schmelzpunkt und relativ geringe Abdampfraten aufweist. Ferner ermöglicht es diese Materialkombination eine Elektroden emittierende Oberfläche der Gegenelektrode darzustellen, was die Selbstdurchbruchspannung im Spalt zwischen beiliegender Elektrode und Gegenelektrode reduziert. Um die gleiche Selbstdurchbruchspannung für eine Oberfläche der Gegenelektrode zu erreichen, kann der Gasfülldruck im Innern der triggerbaren Funkenstrecke erhöht sein. Durch einen bei erhöhtem Gasfülldruck höheren Stoßquerschnitt für abdampfende Partikel im Gas verringert sich die Kondensation von Material auf der Innenwand zwischen den Elektroden. Ferner sind Partikel des zweiten Materials vorzugsweise nicht so gut elektrisch leitend wie das erste Material, welches bei konventionellen triggerbaren Funkenstrecken die Elektroden nach dem Erreichen einer kritischen Aktivierungszahl kurzschließen würde.

Aufgrund dieser Zusammenhänge ist es möglich, die mögliche Impulszahl für die triggerbare Funkenstrecke merklich zu erhöhen, z.B. zu verdoppeln.

Das zweite Material ist dabei durch Erhitzen aus dem Material einer Glaspaste hervorgegangen. Die erhitzte Glaspaste ist somit eine erhitzte Paste, die Natriumsilikat, ein Fensterglas, Ceroxid, Yttriumoxid, Titan und Wasser umfasst. Das Wasser soll dabei als Trägermedium dienen, um die übrigen Bestandteile in Form einer Paste bereitzustellen. Das Wasser kann - zum Beispiel zu einem großen Teil - durch Erhitzen entfernt werden, nachdem die Paste auf das erste Material aufgetragen wurde.

Anspruch 1 definiert, dass die Paste Natriumsilikat mit einem Massenanteil zwischen 50% und 70% enthält. Der Massenanteil des Fensterglases kann zwischen 15% und 27% betragen. Der Massenanteil von Ceroxid kann zwischen 10% und 20% betragen. Der Massenanteil von Yttriumoxid in der Paste kann zwischen 1% und 5% betragen. Titan kann mit einem Massenanteil zwischen 0,5% und 1,7% in der Paste enthalten sein. Wasser kann den Rest oder einen Teil des Rests der Zusammensetzung der Paste ausmachen.

In einer Ausführungsform der Paste enthält die Paste Natriumsilikat mit einem Massenanteil von 60 %, ein Fensterglas mit einem Massenanteil von 21 %, Ceroxid mit einem Massenanteil von 15 %, Yttriumoxid mit einem Massenanteil von 3,2 % und metallisches Titan mit einem Massenanteil von 1,1 %.

Es ist möglich, dass der Spalt zwischen der Triggerelektrode und der Gegenelektrode eine Breite B mit 5 mm ≤ B ≤ 15 mm hat.

Es ist möglich, dass das zweite Material zwischen dem ersten Material und dem Spalt angeordnet ist und eine Dicke D mit 50 µm ≤ D ≤ 200 µm hat.

Die Anordnung des zweiten Materials ist dabei vorzugsweise so, dass das zweite Material das erste Material der Gegenelektrode zumindest an den Stellen bedeckt, die für den Stromtransport zwischen den Elektroden beim Aktivieren der Funkenstrecke vorgesehen sind.

Die Triggerelektrode, die beiliegende Elektrode und die Gegenelektrode können zumindest teilweise in einem hermetisch abgedichteten Hohlraum angeordnet sein.

Die beiliegende Elektrode kann mit einem ersten externen Kontakt verbunden oder verschaltet sein. Die Gegenelektrode kann mit einem zweiten elektrischen Außenkontakt verbunden und/oder verschaltet sein. Die Triggerelektrode kann mit einem dritten externen Kontakt verbunden oder verschaltet sein.

Es ist möglich, dass der Hohlraum Stickstoff und/oder ein Edelgas umfasst.

Der Druck im Innern des Hohlraums kann zwischen 500 mbar und 2 bar betragen.

Es ist möglich, den Abstand zwischen der beiliegenden Elektrode und der Gegenelektrode einerseits, den Fülldruck andererseits und weiterhin die Zusammensetzung des zweiten Materials so zu wählen, dass die schaltbare Funkenstrecke eine Selbstdurchbruchspannung zwischen 10 kV und 35 kV, z.B. 20 kV, beträgt. Der Spalt zwischen beiliegender Elektrode und Gegenelektrode kann dabei eine Breite von 10 mm haben. Die Dicke der Schicht des zweiten Materials der Gegenelektrode kann im Intervall zwischen 50 µm und 200 µm zum Beispiel in Höhe von 100 µm gewählt sein.

Der Betriebsspannungsbereich der triggerbaren Funkenstrecke kann zwischen 7,5 kV und 22 kV betragen. Das kritische Potential zum Auslösen der Funkenstrecke, das an die Triggerelektrode angelegt wird, kann beispielsweise so gewählt sein, dass eine Spannungsüberhöhung von 1 bis 15 kV gegenüber der beiliegenden Elektrode erhalten wird.

Das zweite Material kann als Dickfilm-Beschichtung auf dem ersten Material der Gegenelektrode gebildet sein. Das zweite Material kann beispielsweise in Form einer Paste mit einem Pinsel oder mittels einer vergleichbaren Methode aufgebracht und anschließend getrocknet sein. Das Trocknen des Pastenmaterials kann beispielsweise mit einer Infrarotlampe geschehen.

Vorzugsweise wird das zweite Material auf das erste Material aufgebracht, bevor die Gegenelektrode mit anderen Komponenten der triggerbaren Funkenstrecke verbunden, zum Beispiel verlötet, wird.

Die triggerbare Funkenstrecke kann eine verschlossene Öffnung umfassen. Über die Öffnung kann der Hohlraum der Funkenstrecke mit einem bevorzugten Gas oder einem bevorzugten Gasgemisch gefüllt werden. Anschließend wird die Öffnung so verschlossen, dass eine hermetische Abdichtung des Hohlraums erhalten wird.

Konventionell aufgebaute triggerbare Funkenstrecken können eine Lebensdauer von etwa zwei Millionen Schaltvorgängen aufweisen. Bei vergleichbaren geometrischen Abmessungen der äußeren Form der Funkenstrecke und des wesentlichen inneren Aufbaus der Funkenstrecke kann durch den oben beschriebenen Aufbau der Gegenelektrode die Lebensdauer auf vier Millionen Aktivierungen erhöht werden.

Die Glimmbrennspannung kann im Bereich von etwa 1000 V liegen. Die Bogenbrennspannung kann bei etwa 100 V liegen.

Die triggerbare Funkenstrecke kann in einem Schaltkreis in Verbindung mit einer elektrischen Last und einem Energiespeicher, zum Beispiel einem Kondensator, Verwendung finden.

Entsprechend umfasst ein Schaltkreis eine elektrische Last, eine triggerbare Funkenstrecke, wie oben beschrieben, und einen Kondensator. Die triggerbare Funkenstrecke ist in Serie mit der Last verschaltet. Der Kondensator liegt parallel zur Serienverschaltung.

Der Kondensator ist vorzugsweise hochspannungsfest und ist dazu vorgesehen, mit einer externen DC (Gleichspannung) Hochspannung aufgeladen zu werden. Die Hochspannung kann dabei die Betriebsspannung der Funkenstrecke in Höhe von etwa 7,5 kV bis 22 kV betragen. Der Kondensator kann eine Kapazität zwischen 10 nF und 1300 nF, zum Beispiel 100 nF, aufweisen.

Die Last im Schaltkreis kann zum Beispiel ein Generator zur Erzeugung akustischer Stoßwellen sein. Mittels der Funkenstrecke und des Kondensators können so zum Beispiel Apparate zur Behandlung von Nierensteinen oder Gallensteinen und dergleichen sein.

Dazu trennt die Funkenstrecke die Last galvanisch von zumindest einer Elektrode des Kondensators. Vorzugsweise wenn der Kondensator mit der gewünschten elektrischen Ladung gefüllt ist, wird die Funkenstrecke durch Anlegen des entsprechenden Signals an die Triggerelektrode ausgelöst und die elektrische Energie des Kondensators an die Last abgegeben.

Als Kondensator kommen dabei vorzugsweise hochspannungsfeste Folienkondensatoren in Frage, die ihre Energie in einem sehr kurz andauernden Puls, zum Beispiel innerhalb von 50 ns, an die Last abgeben können.

Ein Verfahren entsprechend Anspruch 7 zur Herstellung einer triggerbaren Funkenstrecke umfasst die folgenden Schritte:
- Bereitstellen einer Triggerelektrode und Materialien für eine beiliegende Elektrode und/oder eine Gegenelektrode,
- Bereitstellen eines ersten Materials,
- Bereitstellen eines zweiten Materials, das eine niedrigere Elektronen-Austrittsarbeit als das erste Material hat,
- Bilden einer beiliegenden Elektrode und/oder einer Gegenelektrode durch Beschichten des ersten Materials mit dem zweiten Material.

Das zweite Material kann dabei in Form einer wässrigen Paste bereitgestellt werden. Die Paste kann mittels eines Dickschicht-Verfahrens auf das erste Material aufgetragen werden.

Es ist möglich, dass die Paste nach dem Auftragen getrocknet wird.

Es ist möglich, dass das erste Material nach dem Trocknen verlötet wird. Das zweite Material hat einen Glasanteil, der durch das Verlöten das zweite Material fest mit dem ersten Material verbindet.

Die Löttemperatur kann dabei zwischen 850 und 1000 °C, zum Beispiel 920 °C, betragen.

Entsprechend hoch ist auch die Temperatur, die das zweite Material beim Verlöten ausgesetzt **ist.** Dadurch bildet der Glasanteil der Paste eine mechanisch stabile Verbindung an der Phasengrenze zum ersten Material **aus.** Eine entsprechende Hitzebehandlung schützt das erste Material und das zweite Material anschließend auch gut vor Oxidation. Es wird quasi eine Passivierungsschicht auf der ansonsten freiliegenden und bezüglich Korrosion empfindlichen Metalloberfläche des ersten Materials gebildet.

Das Anordnen eines zweiten Materials zur Reduktion der Bogenbrennspannung ist nicht auf die Gegenelektrode beschränkt. Es ist auch möglich, die beiliegende Elektrode entsprechend zu beschichten und auf eine Beschichtung der Gegenelektrode zu verzichten.

Auch ist es möglich, ein entsprechendes Material ausschließlich auf der beiliegenden Elektrode vorzusehen oder sowohl die beiliegende Elektrode als auch die Gegenelektrode mit einer Beschichtung zu versehen.

Zentrale Funktionsprinzipien und Details bevorzugter Ausführungsformen werden anhand der beiliegenden schematischen Figuren näher erläutert.

Es zeigen:
- Figur 1: eine mögliche Anordnung der Komponenten der Funkenstrecke,
- Figur 2: einen möglichen Ersatzschaltkreis einer Anwendung der Funkenstrecke.

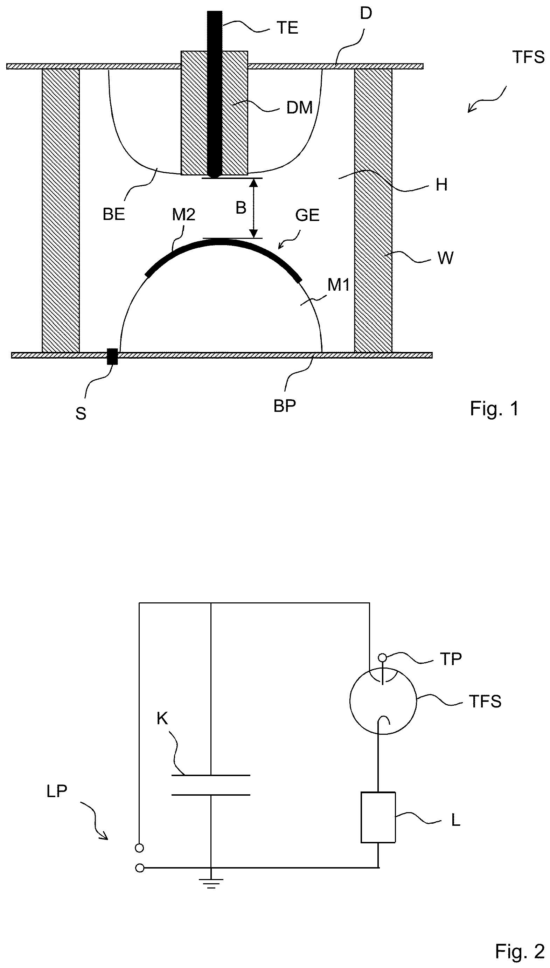

Figur 1 zeigt einen möglichen Aufbau der triggerbaren Funkenstrecke TFS in einer Querschnittsansicht. In einem Hohlraum H stehen sich eine beiliegende Elektrode BE und eine gegenüberliegende Elektrode GE gegenüber. Die beiliegende Elektrode ist in der Nähe einer Triggerelektrode TE angeordnet. Es ist möglich, dass die beiliegende Elektrode BE im Wesentlichen rotationssymmetrisch ausgebildet ist und eine Ausnehmung im Innern hat. Im Innern der Ausnehmung ist die Triggerelektrode TE angeordnet und durch ein dielektrisches Material DM vom Material der beiliegenden Elektrode BE getrennt und isoliert. Zwischen der beiliegenden Elektrode BE und der gegenüberliegenden Elektrode GE beziehungsweise zwischen der Triggerelektrode TE und der gegenüberliegenden Elektrode GE existiert ein Spalt. Vorzugsweise ragt die Triggerelektrode TE in Richtung der gegenüberliegenden Elektrode GE über die Abmessungen der beiliegenden Elektrode BE hinaus. Dadurch wird es der Triggerelektrode TE vereinfacht, einen elektrischen Überschlag zwischen der beiliegenden Elektrode und der gegenüberliegenden Elektrode GE zu induzieren, wenn an die Triggerelektrode TE ein entsprechendes Signal angelegt wird und zwischen der beiliegenden Elektrode BE und der gegenüberliegenden Elektrode GE eine entsprechende Hochspannung anliegt.

Entsprechend ist der Abstand B zwischen der Triggerelektrode TE und der gegenüberliegenden Elektrode GE vorzugsweise kleiner als der Abstand zwischen der beiliegenden Elektrode BE und der gegenüberliegenden Elektrode GE. Der Abstand zwischen der Triggerelektrode TE und der beiliegenden Elektrode BE ist vorzugsweise kleiner als der Abstand zwischen der Triggerelektrode TE und der gegenüberliegenden Elektrode GE.

Der Hohlraum H ist vorzugsweise durch ein im nicht aktivierten Zustand dielektrisches Gas oder Gasgemisch gefüllt, das über eine Öffnung, nach der Herstellung geschlossen durch den Stopfen S, eingefüllt ist.

Die gegenüberliegende Elektrode GE hat zumindest zwei Komponenten mit einer Phasengrenze dazwischen. Eine erste Phase wird durch ein erstes Material M1 gebildet. Eine zweite Phase wird durch ein zweites Material M2 gebildet. Zwischen dem ersten Material M1 und dem zweiten Material M2 ist entsprechend eine Phasengrenze ausgebildet.

Das zweite Material M2 ist vorzugsweise als sogenannte Dickschicht auf dem ersten Material M1 angeordnet. Das zweite Material M2 ist vorzugsweise an denjenigen Stellen auf der Oberseite des ersten Materials M1 angeordnet, die für einen Ladungstransport beim Aktivieren vorgesehen sind.

Das zweite Material M2 reduziert die Bogenbrennspannung der Funkenstrecke. Das zweite Material M2 stellt eine Elektroden-Aktivierungs-Masse dar, die Elektronen bereitwilliger austreten lässt als das erste Material M1. Dadurch ist die Verlustleitung der triggerbaren Funkenstrecke reduziert, wodurch auch der Materialtransport von der Gegenelektrode GE zu einer oder mehrerer Seitenwänden W reduziert ist, sodass die galvanische Trennung der gegenüberliegenden Elektroden auch nach einer hohen Anzahl von Aktivierungen sicher gewährleistet ist.

Die Wand oder die Wände W bestehen vorzugsweise aus einem dielektrischen Material, zum Beispiel einer Keramik. Ein Deckel D, an dem das Material der beiliegenden Elektrode BE befestigt ist, und eine Bodenplatte BP, auf der das erste Material M1 angeordnet ist, können elektrisch leitend sein und zum Beispiel ein Metall oder eine Legierung umfassen und die externen Anschlüsse neben dem Anschluss der Triggerelektrode TE darstellen.

Figur 2 zeigt eine mögliche Anwendung der triggerbaren Funkenstrecke TFS in einem Schaltkreis. Die triggerbare Funkenstrecke TFS ist in Serie mit einer Last L verschaltet.

Die Serienverschaltung aus Last L und triggerbarer Funkenstrecke TFS ist parallel mit einem Kondensator K verschaltet. Über einen Ladeport LP kann der Kondensator mit einer Hochspannung beaufschlagt und mit entsprechender Ladung geladen werden. Über einen Triggerport TP, der mit der Triggerelektrode TE der triggerbaren Funkenstrecke TFS verschaltet ist, kann eine Aktivierung der Funkenstrecke ausgelöst werden. Dabei wird die triggerbare Funkenstrecke elektrisch leitend und der Kondensator K gibt seine elektrische Energie in einem kurzen Puls mit einem hohen erreichbaren Strom, zum Beispiel einige Kiloampere, an die Last ab.

Eine der Elektroden der Funkenstrecke kann mit einem Referenzpotenzial, z. B. Masse, verbunden sein.

Die triggerbare Funkenstrecke, der Schaltkreis mit der triggerbaren Funkenstrecke und das Verfahren zur Herstellung einer triggerbaren Funkenstrecke sind nicht auf die gezeigten Ausführungsformen beschränkt. Funkenstrecken mit weiteren Komponenten, zum Beispiel Elementen zur Verbesserung der Isolation zwischen beiliegender Elektrode und Gegenelektrode und Schaltkreise mit zusätzlichen Schaltungselementen und Verfahren mit zusätzlichen Herstellungsschritten werden ebenfalls umfasst.

### Bezugszeichenliste

- B: Breite des Spalts zwischen der Gegenelektrode und der Triggerelektrode
- BE: beiliegende Elektrode
- BP: Bodenplatte
- D: Deckel
- DM: dielektrisches Material
- GE: Gegenelektrode
- H: Hohlraum
- K: Kondensator
- L: Last
- LP: Ladeport
- M1: erstes Material der Gegenelektrode
- M2: zweites Material der Gegenelektrode
- S: Stopfen
- TE: Triggerelektrode
- TFS: triggerbare Funkenstrecke
- TP: Triggerport
- W: Seitenwand der Funkenstrecke

## Patentansprüche

1. Triggerbare Funkenstrecke (TFS), umfassend
- eine Triggerelektrode (TE),
- eine beiliegende Elektrode (BE) bei der Triggerelektrode (TE),
- eine Gegenelektrode (GE),
- einen Spalt zwischen der Gegenelektrode (GE) und der beiliegenden Elektrode,
wobei
- der Abstand zwischen Triggerelektrode (TE) und beiliegender Elektrode kleiner ist als der Abstand zwischen der Triggerelektrode (TE) und der Gegenelektrode (GE),
- der Abstand zwischen Triggerelektrode (TE) und Gegenelektrode (GE) kleiner ist als der Abstand zwischen der beiliegenden Elektrode und der Gegenelektrode (GE),
- die Gegenelektrode (GE) und/oder die beiliegende Elektrode (BE) eine erste Phase aus einem ersten Material (M1) und darauf eine Beschichtung als zweite Phase aus einem zweiten Material (M2) umfasst und
- das zweite Material (M2) eine niedrigere Elektronen-Austrittsenergie als das erste Material (M1) hat,
**dadurch gekennzeichnet, dass**
- das erste Material (M1) Molybdän, Wolfram, Chrom, Kupfer oder Lanthan umfasst oder aus Molybdän, Wolfram, Chrom, Kupfer oder Lanthan besteht und
- das zweite Material (M2) durch Erhitzen aus einer Glaspaste hervorgegangen ist, so dass es die erhitzte Glaspaste umfasst, und die erhitzte Glaspaste eine erhitzte Paste, umfassend
- Natrium Silikat mit einem Massenanteil zwischen 50% und 70%,
- einem Fensterglas mit einem Massenanteil zwischen 15% und 27%,
- Ceroxid mit einem Massenanteil zwischen 10% und 20%,
- Yttriumoxid mit einem Massenanteil zwischen 1% und 5%,
- Titan mit einem Massenanteil zwischen 0,5% und 1,7% und
- Wasser
ist.

2. Triggerbare Funkenstrecke nach dem vorherigen Anspruch, wobei der Spalt zwischen der Triggerelektrode (TE) und der Gegenelektrode (GE) eine Breite B mit 5 mm ≤ B ≤ 15 mm hat.

3. Triggerbare Funkenstrecke nach einem der vorherigen Ansprüche, wobei das zweite Material (M2) zwischen dem ersten Material (M1) und dem Spalt angeordnet ist und eine Dicke D mit 50 µm ≤ D ≤ 200 µm hat.

4. Triggerbare Funkenstrecke nach einem der vorherigen Ansprüche, wobei die Triggerelektrode (TE), die beiliegende Elektrode (BE) und die Gegenelektrode (GE) zumindest teilweise in einem hermetisch abgedichteten Hohlraum angeordnet sind.

5. Triggerbare Funkenstrecke nach dem vorherigen Anspruch, wobei der Hohlraum Stickstoff und/oder ein Edelgas umfasst.

6. Schaltkreis, umfassend
- eine elektrische Last (L),
- eine triggerbare Funkenstrecke (TFS) nach einem der vorherigen Ansprüche, die in Serie mit der Last (L) verschaltet ist und
- einen Kondensator (K), der parallel zur Serienverschaltung aus Last (L) und Funkenstrecke (TFS) verschaltet ist.

7. Verfahren zur Herstellung einer triggerbaren Funkenstrecke (TFS) nach einem der Ansprüche 1 bis 5, umfassend die Schritte:
- Bereitstellen einer Triggerelektrode (TE) und Materialien für eine beiliegende Elektrode (BE) und/oder eine Gegenelektrode (GE),
- Bereitstellen eines ersten Materials (M1),
- Bereitstellen eines zweiten Materials (M2), das eine niedrigere Elektronen-Austrittsarbeit als das erste Material (M1) hat,
- Bilden einer beiliegenden Elektrode und/oder einer Gegenelektrode (GE) durch Beschichten des ersten Materials (M1) mit dem zweiten Material (M2).

8. Verfahren nach dem vorherigen Anspruch, wobei
- das zweite Material (M2) in Form einer wässrigen Paste bereitgestellt wird und
- die Paste mittels eines Dickschicht-Verfahrens auf das erste Material (M1) aufgetragen wird.

9. Verfahren nach dem vorherigen Anspruch, bei dem die Paste nach dem Auftragen getrocknet wird.

10. Verfahren nach dem vorherigen Anspruch, bei dem das erste Material (M1) nach dem Trocknen verlötet wird, wobei das zweite Material (M2) einen Glasanteil besitzt, der durch das Verlöten das zweite Material (M2) fest mit dem ersten Material (M1) verbindet.

## Claims

1. Triggerable spark gap (TFS), comprising
- a trigger electrode (TE),
- an adjacent electrode (BE) at the trigger electrode (TE),
- a counter electrode (GE),
- a gap between the counter electrode (GE) and the adjacent electrode,
wherein
- the distance between the trigger electrode (TE) and the adjacent electrode is less than the distance between the trigger electrode (TE) and the counter electrode (GE),
- the distance between the trigger electrode (TE) and the counter electrode (GE) is less than the distance between the adjacent electrode and the counter electrode (GE),
- the counter electrode (GE) and/or the adjacent electrode (BE) comprises a first phase consisting of a first material (M1) and on it a coating as a second phase consisting of a second material (M2), and
- the second material (M2) has a lower electron work function than the first material (M1), **characterized in that**
- the first material (M1) comprises molybdenum, tungsten, chromium, copper or lanthanum or consists of molybdenum, tungsten, chromium, copper or lanthanum, and
- the second material (M2) is produced by heating from a glass paste, so that it comprises the heated glass paste, and the heated glass paste is a heated paste comprising
- sodium silicate with a mass fraction of between 50% and 70%,
- a sheet glass with a mass fraction of between 15% and 27%,
- cerium oxide with a mass fraction of between 10% and 20%,
- yttrium oxide with a mass fraction of between 1% and 5%,
- titanium with a mass fraction of between 0.5% and 1.7% and
- water.

2. Triggerable spark gap according to the preceding claim, wherein the gap between the trigger electrode (TE) and the counter electrode (GE) has a width B with 5 mm ≤ B ≤ 15 mm.

3. Triggerable spark gap according to one of the preceding claims, wherein the second material (M2) is arranged between the first material (M1) and the gap and has a thickness D with 50 µm ≤ D ≤ 200 µm.

4. Triggerable spark gap according to one of the preceding claims, wherein the trigger electrode (TE), the adjacent electrode (BE) and the counter electrode (GE) are at least partially arranged in a hermetically sealed cavity.

5. Triggerable spark gap according to the preceding claim, wherein the cavity comprises nitrogen and/or a noble gas.

6. Circuit, comprising
- an electrical load (L),
- a triggerable spark gap (TFS) according to one of the preceding claims, which is connected in series with the load (L), and
- a capacitor (K), which is connected in parallel with the series circuit of the load (L) and the spark gap (TFS).

7. Method for producing a triggerable spark gap (TFS) according to one of Claims 1 to 5, comprising the steps:
- providing a trigger electrode (TE) and materials for an adjacent electrode (BE) and/or a counter electrode (GE),
- providing a first material (M1),
- providing a second material (M2), which has a lower electron work function than the first material (M1),
- forming an adjacent electrode and/or a counter electrode (GE) by coating the first material (M1) with the second material (M2).

8. Method according to the preceding claim, wherein
- the second material (M2) is provided in the form of an aqueous paste and
- the paste is applied onto the first material (M1) by means of a thick-film method.

9. Method according to the preceding claim, wherein the paste is dried after application.

10. Method according to the preceding claim, wherein the first material (M1) is soldered after drying, the second material (M2) having a glass component which bonds the second material (M2) firmly to the first material (M1) by the soldering.

## Revendications

1. Éclateur à déclenchement (TFS), comprenant
- une électrode de déclenchement (TE),
- une électrode jointe (BE) au niveau de l'électrode de déclenchement (TE),
- une contre-électrode (GE),
- un interstice entre la contre-électrode (GE) et l'électrode jointe,
procédé selon lequel
- la distance entre l'électrode de déclenchement (TE) et l'électrode jointe est inférieure à la distance entre l'électrode de déclenchement (TE) et la contre-électrode (GE),
- la distance entre l'électrode de déclenchement (TE) et la contre-électrode (GE) est inférieure à la distance entre l'électrode jointe et la contre-électrode (GE),
- la contre-électrode (GE) et/ou l'électrode jointe (BE) comprend une première phase d'un premier matériau (M1) et, sur celle-ci, un revêtement en tant que seconde phase d'un second matériau (M2), et
- le second matériau (M2) présente une énergie de sortie d'électrons inférieure à celle du premier matériau (M1), **caractérisé en ce que**
- le premier matériau (M1) comprend du molybdène, du tungstène, du chrome, du cuivre ou du lanthane, ou est constitué de molybdène, de tungstène, de chrome, de cuivre ou de lanthane, et
- le second matériau (M2) est obtenu par chauffage d'une pâte de verre, de sorte qu'il comprend la pâte de verre chauffée, et la pâte de verre chauffée est une pâte chauffée, comprenant
- du silicate de sodium avec un pourcentage en masse compris entre 50 % et 70 %,
- du verre à vitre avec un pourcentage en masse compris entre 15 % et 27 %,
- de l'oxyde de cérium avec un pourcentage en masse compris entre 10 % et 20 %,
- de l'oxyde d'yttrium avec un pourcentage en masse compris entre 1 % et 5 %,
- du titane avec un pourcentage en masse compris entre 0,5 % et 1,7 % et
- de l'eau.

2. Éclateur à déclenchement selon la revendication précédente, dans lequel l'interstice entre l'électrode de déclenchement (TE) et la contre-électrode (GE) présente une largeur B telle que 5 mm ≤ B ≤ 15 mm.

3. Éclateur à déclenchement selon l'une des revendications précédentes, dans lequel le second matériau (M2) est disposé entre le premier matériau (M1) et l'interstice et présente une épaisseur D telle que 50 µm ≤ D ≤ 200 µm.

4. Éclateur à déclenchement selon l'une des revendications précédentes, dans lequel l'électrode de déclenchement (TE), l'électrode jointe (BE) et la contre-électrode (GE) sont disposées au moins partiellement dans une cavité fermée de manière hermétique.

5. Éclateur à déclenchement selon la revendication précédente, dans lequel la cavité comprend de l'azote et/ou un gaz noble.

6. Circuit, comprenant
- une charge électrique (L),
- un éclateur à déclenchement (TFS) selon l'une des revendications précédentes, qui est monté en série avec la charge (L) et
- un condensateur (K), qui est monté en parallèle avec la connexion en série de la charge (L) et de l'éclateur (TFS).

7. Procédé de fabrication d'un éclateur à déclenchement (TFS) selon l'une des revendications 1 à 5, comprenant les étapes consistant à :
- fournir une électrode de déclenchement (TE) et des matériaux pour une électrode jointe (BE) et/ou une contre-électrode (GE),
- fournir un premier matériau (M1),
- fournir un second matériau (M2) présentant un travail de sortie d'électrons inférieur à celui du premier matériau (M1),
- former une électrode jointe et/ou une contre-électrode (GE) en revêtant le premier matériau (M1) du second matériau (M2).

8. Procédé selon la revendication précédente, dans lequel
- le second matériau (M2) est fourni sous la forme d'une pâte aqueuse et
- la pâte est appliquée sur le premier matériau (M1) au moyen d'un procédé en couche épaisse.

9. Procédé selon la revendication précédente, dans lequel la pâte est séchée après l'application.

10. Procédé selon la revendication précédente, dans lequel le premier matériau (M1) est brasé après le séchage, le second matériau (M2) possédant une fraction de verre qui, par le brasage, lie fermement le second matériau (M2) au premier matériau (M1).
